# EUROPEAN PATENT APPLICATION

(11) **EP 1 249 872 A2**
(43) Date of publication of application: **16.10.2002**
(21) Application number: 02008132.9
(22) Date of filing: 11.04.2002
(51) Int. Cl.: H01L 29/737

(54) **GaN HBT superlattice base structure**

(30) Priority: 12.04.2001 US 833372
(71) Applicant: TRW Inc., Redondo Beach, California 90278 (US)
(72) Inventor: Wojtowicz, Michael, Long Beach, CA 90815 (US)
(74) Representative: Schmidt, Steffen J., Dipl.-Ing.

(57) **Abstract**

A heterojunction bipolar transistor (HBT) (20) with alternating layers of gallium nitride (GaN) and aluminum gallium nitride (AlGaN) with varying Al composition forming a graded superlattice structure in the base layer (28) includes. The thin layers of AIGaN in the base layer (28) increases the base p-type carrier concentration. Grading of the Al composition in the thin AlGaN layers induces an electrostatic field across the base layer (28) that increases the carrier velocity and reduces the carrier transit time. The structure thus decreases the transit time and at the same time increases the p-type carrier concentration to improve the operating efficiency of the device.

## Description

### BACKGROUND OF THE INVENTION

### 1. Field of the Invention

The present invention relates to a heterojunction bipolar transistor (HBT) and more particularly to an HBT and method for making an HBT having higher efficiency and higher frequency operation without the fabrication complexities of known HBTs.

### 2. Description of the Prior Art

Heterojunction bipolar transistors (HBT) are generally known in the art. Examples of such devices are disclosed in U.S. Patent Nos. 5,349,201; 5,365,077; 5,404,025 and commonly owned U.S. Patent No. 5,448,087 and 5,672,522, all hereby incorporated by reference. Such HBTs are known to be used in applications requiring relatively high frequency response and wider temperature range of operation and are used, for example, in power amplifiers, low noise amplifiers and power conversion electronic circuits in satellite and solar applications.

Typical HBT's are normally formed on a semiconducting substrate, such as gallium arsenide (GaAs) or Indium phosphide (InP). Collector, base and emitter layers are epitaxially formed on top of the substrate. More particularly, known HBTs are known to be formed with an n⁺ doped subcollector layer directly on top of the substrate followed by n⁻ collector layer. A p⁺ base layer is formed on top of the collective layer followed by n⁺ doped emitter layer. Contacts are formed on the subcollector base and emitter layers for connection of the device to an external electrical circuit.

When an input voltage is applied across the base emitter junction of a bipolar transistor, the base emitter junction is forward biased resulting in electrons being ejected from the emitter layer into the base layer. When the electrons reach the base-collector junction, for example, by diffusion, electric fields direct the electrons to the collector layer.

In a homojunction bipolar transistor, holes are ejected into the emitter layer into the base layer as a result of the forward biased emitter junction. The injection of holes into the base layer results in a lower cut off frequency and lower current gain of the device resulting in lower efficiency and a lower frequency of operation of the device. In order to reduce the hole injection, the base p-doping is normally made lower than the emitter. Unfortunately, such a configuration results in a base layer with more resistance which, in turn, reduces the output power of the device.

In heterojunction bipolar transistors, wider band-gap materials are used for the emitter layer which acts as an energy barrier which reduces the hole injection thus improving the base transit time and cut off frequency of the device. In order to further improve the operation of the device, the p-doping of the base layer is made as large as possible in order to reduce the resistance of the base layer.

U.S. Patent No. 5,349,201 discloses an HBT which utilizes an alternate material system to decrease the base transit time, increase the operating frequency, and increase the current gain.

### SUMMARY OF THE INVENTION

Briefly the present invention relates to a heterojunction bipolar transistor (HBT) with a base layer formed from alternating layers of gallium nitride (GaN) and aluminum gallium nitride (AlGaN) forming a graded superlattice structure with the Al composition of the AlGaN layers graded in such a way as to establish a built-in electric field in the base region. The thin layers of AlGaN in the base layer allow the p-type dopant in these layers to tunnel into the GaN layers thus reducing the p-type dopant activation energy and increasing the base p-type carrier concentration. The grading of the Al composition in the AlGaN layers induces an electrostatic field across the base layer that increases the velocity of electrons ejected from the emitter into the base. The structure thus decreases the injected electron transit time and at the same time increases the p-type carrier concentration to improve the operating efficiency of the device.

### DESCRIPTION OF THE DRAWINGS

These and other objects of the present invention will be readily understood with reference to the following specification and attached drawings wherein:

FIG. 1 illustrates an HBT with a graded superlattice base layer in accordance with the present invention.

FIG. 2 shows a graph of the Al composition in the base layer as a function of distance from the emitter for one embodiment of the invention.

### DETAIL DESCRIPTION

The present invention relates to a heterojunction bipolar transistor (HBT) with improved base transit time and increased p-type carrier concentration in the base which provides for higher efficiency power operation and higher frequency operation. In HBTs formed from gallium nitride/aluminum gallium nitride (GaN/AlGaN) material systems, the p-type carrier concentration is limited by high acceptor activation energies. The present invention utilizes alternating layers of GaN and AlGaN to form a graded superlattice which effectively increases the p-type carrier concentration by effectively reducing the activation energy. Higher p-type carrier concentration allows for higher efficiency power operation and high frequency operation. The graded superlattice results in the band gap energy across the base being graded. The grading induces an electrostatic field across the base which increases the carrier velocity which reduces the carrier transit time. For example, for the configuration discussed below, the acceptor activation energy of an HBT has been shown to be decreased, for example from 0.125 eV to 0.09eV. This results in an increase of the base p-type carrier concentration from 5x10¹⁷ cm⁻³ to 2x10¹⁸ cm⁻³ and a reduction of the base transit time from 45 ps to 20 ps.

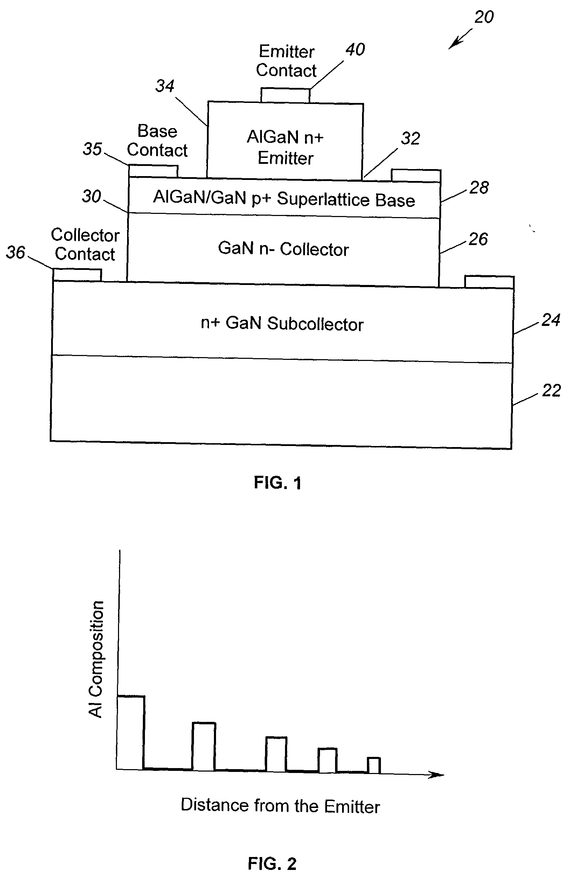

Referring to FIG. 1, an HBT in accordance with the present invention is illustrated and generally identified with the reference numeral 20. The HBT 20 includes a semiinsulating substrate 22, formed from, for example, sapphire or silicon carbide (SiC). An n⁺ gallium nitride (GaN) subcollector layer 24 is formed on top of these substrate 22. A method for epitaxially growing gallium nitride layers is disclosed in U.S. Patent No. 5,725,674, hereby incorporated by reference. The subcollector layer 24 may be grown using molecular beam epitaxy (MBE) to a thickness of, for example, 1000 nm and doped with silicon (Si) to a concentration of 6x10¹⁸ cm⁻³. An n-GaN collector layer 26 is formed over a portion of the subcollector layer 24, for example by MBE. Conventional photolithographic techniques may be used to form the collector layer 26 over only a portion of the subcollector layer 24.

In accordance with an important aspect of the invention, the base layer 28 is formed with a non constant band gap energy with a low value at the collector base interface 30 and a higher value at the emitter base interface 32 which creates an electrostatic field in the base layer 28 that increases the carrier velocity and decreases the transit time of the device. For example, the base layer 29 may be formed from a superlattice consisting of alternating layers of AlGaN/GaN. U.S. Patent No. 5,831,277 discloses a system for forming AlₓN₍₁₋ₓ₎/GaN super lattice structures, hereby incorporated by reference. In particular, the superlattice base layer 28 is formed on top of the collector layer 26. The superlattice base layer 28, formed to 150nm total thickness by MBE from periodic AlGaN-GaN layers. Each GaN layer maybe undoped and formed to a thickness of 3nm. The AlGaN layers maybe formed to a thickness of 1 nm thick, doped with magnesium Mg to a level of 1x10¹⁹ cm⁻³, where the aluminum Al composition is 0.05 at the collector base interface 30 and is continuously increased toward the emitter base interface 32 to a final value of 0.30 at the emitter base interface 32. FIG. 2 shows an example of the Al composition in the base layer as a function of distance from the emitter-base metallurgical junction for one embodiment of the invention. Referring back to FIG. 1, the thin layers of AlGaN in the alternating AlGaN/GaN layers forming the base layer 28 increases the p-type concentration in base layer 28 which increases the high power efficiency and high frequency operation.

An emitter layer 34 is formed on top of the base layer 28, for example by MBE. The emitter layer 34 may be formed from AlGaN to a thickness of 150 nm and doped with silicon at a concentration of 6x10¹⁸ cm⁻³.

Collector, base and emitter contacts are formed by conventional metal deposition and lift-off techniques. More particularly, a collector contact 36 is formed on the subcollector layer 24; a base contact 38 is formed on top of the base layer 28, while an emitter contact 40 is formed on top of the emitter layer 34.

Obviously, many modifications and variations of the present invention are possible in light of the above teachings. Thus, it is to be understood that, within the scope of the appended claims, the invention may be practiced otherwise than as specifically described above.

What is claimed and desired to be secure by Letters Patent of the United States is:

## Claims

1. A heterojunction bipolar transistor (HBT) comprising:
a substrate;
an n+ doped GaN subcollector layer;
an n- doped GaN collector layer;
a base layer formed on top of said collector layer defining a base collector interface formed from alternating layers of AlGaN/GaN forming a superlattice;
an n+ doped AlGaN layer;
an n+ AlGaN emitter layer formed on top of said base layer defining an emitter base interface;
a base contact formed on said base layer;
a collector contact formed on said subcollector; and
an emitter contact formed on said emitter.

2. The HBT as recited in claim 1, wherein the Al concentration in said AlGaN layers is irregular.

3. A heterojunction bipolar transistor (HBT) comprising:
a substrate;
an n+ doped GaN subcollector layer;
an n- doped GaN collector layer;
a base layer formed on top of said collector layer defining a base collector interface formed from alternating layers of AlGaN/GaN forming a superlattice;
an n+ doped AlGaN layer;
an n+ AlGaN emitter layer formed on top of said base layer defining an emitter base interface, the Al concentration at said emitter base interface being greater at said emitter base interface than said base collector interface;
a base contact formed on said base layer;
a collector contact formed on said subcollector; and
an emitter contact formed on said emitter.

4. The HBT as recited in claim 1, wherein said alternating AlGaN layers are formed such that the Al concentration is graded.

5. A heterojunction bipolar transistor (HBT) comprising:
a substrate formed from a material selected from the group consisting of sapphire and silicon carbide;
an n+ doped GaN subcollector layer;
an n- doped GaN collector layer;
a base layer formed on top of said collector layer defining a base collector interface formed from alternating layers of AlGaN/GaN forming a superlattice;
an n+ doped AlGaN layer;
an n+ AlGaN emitter layer formed on top of said base layer defining an emitter base interface;
a base contact formed on said base layer;
a collector contact formed on said subcollector; and
an emitter contact formed on said emitter.

6. A method for fabricating a heterojunction bipolar transistor comprising the steps:
(a) forming a subcollector layer on a substrate;
(b) forming a collector layer on said subcollector layer;
(c) forming a base layer on said collector defining a base collector interface; said base layer formed with an irregular band gap energy;
(d) forming an emitter layer on said base layer defining a base collector interface; and
(e) forming contacts on said base, subcollector said emitter layers.

7. The process as recited in claim 6, wherein said base layer is formed.

8. A method for fabricating a heterojunction bipolar transistor comprising the steps:
(a) forming a subcollector layer on a substrate;
(b) forming a collector layer on said subcollector layer;
(c) forming a base layer as a superlattice of alternating layers of AlGaN/GaN on said collector defining a base collector interface; said base layer formed with an irregular band gap energy;
(d) forming an emitter layer on said base layer defining a base collector interface; and
(e) forming contacts on said base, subcollector said emitter layers.
